# EUROPÄISCHE PATENTANMELDUNG

(11) **EP 0 717 447 A1**
(43) Veröffentlichungstag der Anmeldung: **19.06.1996**
(21) Anmeldenummer: 95118893.7
(22) Anmeldetag: 30.11.1995
(51) Int. Cl.: H01L 29/08

(54) **GTO-Thyristor**

(30) Priorität: 13.12.1994 DE 4444310
(71) Anmelder: SIEMENS AKTIENGESELLSCHAFT, D-80333 München (DE)
(72) Erfinder: Gerstenmaier, York, Dr. Dipl.-Phys., 80638 München (DE); Brunner, Heinrich, Dr., 81667 München (DE)

(57) **Zusammenfassung**

Die Rückseitenemitterzone (7) eines GTO-Thyristors ist 0,4 bis 2 µm dick und hat eine Maximaldotierung zwischen 4 x 10¹⁶ und 1 x 10¹⁸ cm⁻³. Damit wird der Tailstrom beim Abschalten reduziert. Vorzugsweise hat die Rückseitenemitterzone keine Kurzschlüsse, wodurch der Zündstrom niedrig gehalten werden kann.

## Beschreibung

Die Erfindung bezieht sich auf einen GTO-Thyristor mit einem Halbleiterkörper, der eine Vorderseitenemitterzone, eine Mittelzone und eine Rückseitenemitterzone hat.

GTO-Thyristoren mit dem erwähnten Aufbau sind Stand der Technik. Sie sind z.B. in der DE 37 42 638 beschrieben worden.

GTO höherer Leistung benötigen eine Schutzbeschaltung, um sie beim Abschalten vor Zerstörung zu sichern. Diese Schutzbeschaltung enthält einen Kondensator, der den Spannungsanstieg am GTO begrenzt. Die Abschaltverluste eines GTO werden in erster Linie durch seinen Tailstrom bestimmt. Durch Verminderung des Tailstroms kann ein steilerer Spannungsanstieg zugelassen werden, wodurch der Beschaltungskondensator verkleinert werden kann.

Es ist bekannt, die Abschaltverluste dadurch herabzusetzen, daß die Trägerlebensdauer durch Protonen- oder Elektronenbestrahlung oder durch die Eindiffusion von Gold- oder Platinatomen verringert wird. Wird keine Rückwärts-Sperrfähigkeit benötigt, kann der Tailstrom auch durch eine rückseitige Kurzschlußstruktur verringert werden.

Die beschriebenen Maßnahmen haben jedoch den Nachteil, daß die Durchlaßspannung und der Zündstrom erhöht wird.

Der Erfindung liegt die Aufgabe zugrunde, die Abschaltverluste eines GTO zu vermindern, ohne die Durchlaßspannung und den Zündstrom zu erhöhen.

Diese Aufgabe wird dadurch gelöst, daß die Rückseitenemitterzone eine Dicke zwischen 0,4 und 2 µm hat und eine Dotierung zwischen 4 x 10¹⁶ und 1 x 10¹⁸ cm⁻³.

Weiterbildungen der Erfindung sind Gegenstand der Unteransprüche.

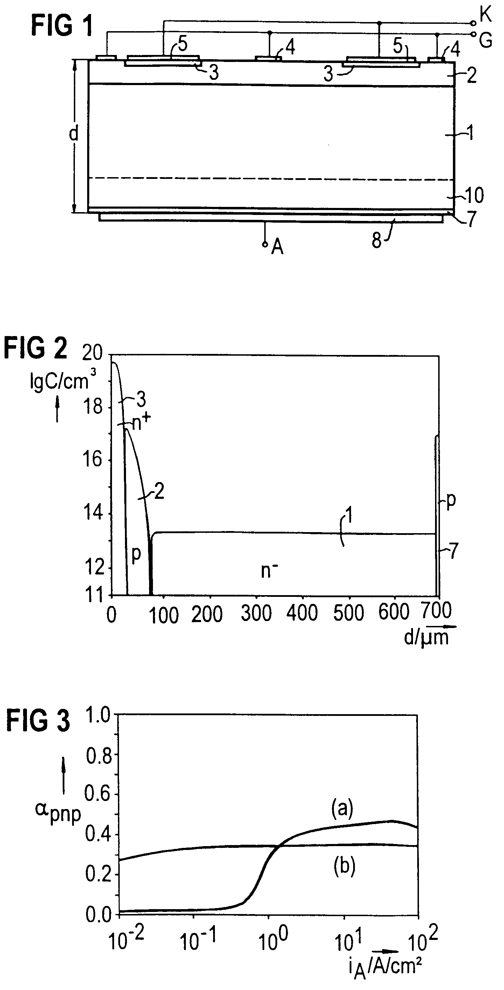

Die Erfindung wird anhand eines Ausführungsbeispiels in Verbindung mit den Figuren 1 und 2 näher erläutert. Es zeigen Figur 1 den Schnitt durch einen GTO-Thyristor gemäß Erfindung und
Figur 2 den Verlauf der Dotierungskonzentration über die Entfernung d von der vorderseitigen (katodenseitigen) Oberfläche des Halbleiterkörpers.

Der GTO hat einen Halbleiterkörper mit einer Mittelzone 1, an die sich auf der Vorderseite eine Basiszone 2 und an der Rückseite eine Emitterzone 7 anschließt. Auf der Vorderseite sind in die Basiszone 2 Emitterzonen 3 planar eingebettet. Sie können auch in Mesatechnik aufgebaut sein. Die vorderseitige Basiszone 2 ist mit Gatekontakten 4 versehen, die vorderseitigen Emitterzonen 3 mit Emitterelektroden 5. Die Leitfähigkeit der Zonen von oben nach unten ist üblicherweise n⁺pn⁻p. Damit sind die Emitterzone 7 der Anodenemitter und die Emitterzonen 3 die Katodenemitter.

Die Rückseitenemitterzone 7 hat eine Dicke zwischen 0,4 und 2 µm und eine Dotierungskonzentration zwischen 4 x 10¹⁶ und 1 x 10¹⁸ cm⁻³. Die Mittelzone 1 hat z.B. eine Dotierung von 2 x 10¹³ cm⁻³ und eine Dicke von 620 µm Die Basiszone 2 hat an der Oberfläche eine Dotierungskonzentration von z.B. 2 x 10¹⁷ cm⁻³ und eine Dicke von 50 µm. Die Emitterzonen 3 können z.B. 2 µm dick sein und eine Oberflächendotierungskonzentration zwischen 1 x 10¹⁹ und 1 x 10²⁰ cm⁻³ haben. Die Emitterzone 7 ist gegenüber bekannten GTO wesentlich dünner und schwächer dotiert. Aus der angegebenen Bemessung der Rückseitenemitterzone resultiert ein im Vergleich zu bekannten GTO geringerer Wirkungsgrad des Rückseitenemitters. Dieser ergibt sich annähernd aus dem Quotienten der Dotierungsdosis in der Rückseitenemitterzone zur Dotierungsdosis in der Mittelzone innerhalb einer Dicke, die einer Diffusionslänge entspricht. Aufgrund des niedrigeren Emitterwirkungsgrades verringert sich die Speicherladung und der Tailstrom. Dabei ändert sich die Durchlaßspannung nicht, wenn die Trägerlebensdauer in der Mittelzone groß genug ist, z.B. 30 µs oder mehr.

Der Rückseitenemitter hat vorzugsweise keine oder sehr schwache Kurzschlüsse. Diese können z.B. zwischen 1 und 10% der Gesamtfläche einnehmen. Wesentlich hierbei ist, daß, die rückseitige Stromverstärkung α im Bereich geringer Stromdichte (im Bereich von 0,01 bis 0,5 A/cm²) z.B. bei mindestens 0,2 liegt (b), während sie bei bekannten GTO mit Shorts auf der Rückseite weit geringer ist als 0,1. Bei hoher Stromdichte z.B. oberhalb 0,5 A/cm² ist die Stromverstärkung α jedoch geringer als bei bekannten GTO (a). Man vergleiche hierzu Figur 3.

Zusätzlich zu den beschriebenen Maßnahmen läßt sich eine Absenkung der Durchlaß- und Schaltverluste erreichen, wenn in bekannter Weise zwischen die Emitterzone 7 und die Mittelzone 1 eine Stopschicht 10 eingefügt wird. Diese Stopschicht ist stärker dotiert als die Mittelzone 1. Ihre Maximaldotierung kann zwischen 1 x 10¹⁴ und 1 x 10¹⁶ cm⁻³ liegen. Die Dicke der Stopschicht kann z.B. 60 µm betragen. Damit läßt sich eine Reduzierung der Gesamtdicke um ca. 100 µm erreichen.

Wie erwähnt, kann die Rückseitenemitterzone mit einigen Kurzschlüssen versehen sein. Dies verhindert in bekannter Weise die Zündung des GTO bei Raumtemperatur. Statt der Kurzschlüsse kann die Trägerlebensdauer der Minoritätsladungsträger rückseitig lokal z.B. durch Bestrahlung mit Protonen oder Heliumkernen in geringer Dosis reduziert werden. Durch diese Maßnahmen steigt allerdings das Zündstromniveau wieder etwas an.

Es versteht sich von selbst, daß der beschriebene GTO wie alle bisher bekannten GTO zur Erhaltung einer möglichst großen Abschaltverstärkung keine katodenseitigen Kurzschlüsse hat.

## Patentansprüche

1. GTO-Thyristor mit einem Halbleiterkörper, der eine Vorderseitenemitterzone, eine Mittelzone und eine Rückseitenemitterzone hat,
**dadurch gekennzeichnet,** daß die Rückseitenemitterzone (7) eine Dicke zwischen 0,4 µm und 2 µm hat und eine Dotierung zwischen 4 x 10¹⁶ und 1 x 10¹⁸ cm⁻³.

2. GTO nach Anspruch 1,
**dadurch gekennzeichnet,** daß zwischen Mittelzone (1) und Rückseitenemitterzone (7) eine Stopschicht (10) liegt, die den gleichen Leitungstyp wie die Mittelzone hat aber eine höhere Dotierung als diese.

3. GTO-Thyristor nach Anspruch 2,
**dadurch gekennzeichnet,** daß die Stopschicht ein Dotierungsmaximum zwischen 1 x 10¹⁴ und 1 x 10¹⁶ cm⁻³ hat und die Mittelzone(1) eine Dotierung zwischen 5 x 10¹² und 2 x 10¹³ cm⁻³ hat.

4. GTO-Thyristor nach einem der Ansprüche 1 bis 3,
**dadurch gekennzeichnet,** daß die Rückseitenemitterzone (7) frei von Kurzschlüssen ist.

5. GTO-Thyristor nach Anspruch 4,
**dadurch gekennzeichnet,** daß die Lebensdauer der Minoritätsladungsträger in der Nähe der Rückseitenemitterzone lokal reduziert ist.

6. GTO-Thyristor nach einem der Ansprüche 1 bis 3,
**dadurch gekennzeichnet,** daß die Rückseitenemitterzone (7) Kurzschlüsse aufweist, die eine Fläche zwischen 1 und 10 % der Gesamtfläche haben.
